# EUROPEAN PATENT APPLICATION

(11) **EP 4 675 685 A1**
(43) Date of publication of application: **07.01.2026**
(21) Application number: 24763640.0
(22) Date of filing: 15.02.2024
(51) Int. Cl.: H01L 27/146, G02B 5/20

(54) **SOLID-STATE IMAGING ELEMENT**

(30) Priority: 02.03.2023 JP 2023032130
(71) Applicant: Toppan Holdings Inc., Tokyo 110-0016 (JP)
(72) Inventor: KATO, Fumiya, Tokyo 110-0016 (JP); TAKAHASHI, Makoto, Tokyo 110-0016 (JP)
(74) Representative: Hoffmann Eitle
(86) International application number: PCT/JP2024/005330
(87) International publication number: WO 2024/181157

(57) **Abstract**

A solid-state imaging element comprises: a semiconductor substrate (11) having a plurality of photoelectric conversion elements (12); a microlens layer (16) having a plurality of microlenses (17) that each cause light (γ) to enter the photoelectric conversion elements (12) of the semiconductor substrate (11); and color filters (14A to 14C) provided between the semiconductor substrate (11) and the microlens layer (16); wherein the color filter (14C) has a transmittance that exhibits a maximum value between wavelengths of 400 nm to 500 nm, while also exhibiting a transmittance of 50% between wavelengths of 460 nm to 490 nm, and has a refractive index that is a smaller value than that of the microlenses (17) at a wavelength in which the transmittance becomes the maximum value.

## Description

### [Technical Field]

The present invention relates to a solid-state imaging element, such as a charge-coupled device or a complementary metal-oxide-semiconductor device.

### [Background Art]

Solid-state imaging elements such as charge-coupled devices (CCDs) and complementary metal-oxide-semiconductor (CMOS) devices, which use photoelectric conversion elements such as photodiodes, are employed in digital still cameras, digital video cameras, and the like. In such solid-state imaging elements, incident light is focused by microlenses, and then delivered to a photoelectric conversion element via a color filter.

In such solid-state imaging elements, although it has been common to use color filters made of a colored composition in which a pigment is dispersed, in recent years, in order to improve the sensitivity and color separation properties, color filters made of a colored composition in which a dye having superior color characteristics to pigments is dispersed are starting to be used (see, for example, PTL 1 below).

### [Citation List]

### [Patent Literature]

PTL 1: JP 2013-015817 A

### [Summary of the Invention]

### [Technical Problem]

In a solid-state imaging element such as that described above, because the microlenses are provided on the color filter, if the refractive index of the color filter becomes larger than the refractive index of the microlenses, there is a concern that the light focusing efficiency toward the photoelectric conversion element may decrease.

As a result, an object of the present invention is to provide a solid-state imaging element capable of preventing a decrease in light focusing efficiency toward a photoelectric conversion element.

### [Solution to Problem]

In order to solve the problem described above, a solid-state imaging element according to the present invention includes: a semiconductor substrate having a plurality of photoelectric conversion elements; a microlens layer having a plurality of microlenses that each cause light to enter the photoelectric conversion elements of the semiconductor substrate; and a color filter provided between the semiconductor substrate and the microlens layer; wherein the color filter has a transmittance that exhibits a maximum value between wavelengths of 400 nm to 500 nm, while also exhibiting a transmittance of 50% between wavelengths of 460 nm to 490 nm, and has a refractive index that is a smaller value than that of the microlenses at a wavelength in which the transmittance becomes the maximum value.

Furthermore, in the solid-state imaging element according to the present invention, it is preferable that, in the solid-state imaging element described above, the color filter contains a blue pigment and a violet dye.

Moreover, in the solid-state imaging element according to the present invention, it is preferable that, in the solid-state imaging element described above, the color filter further contains a violet pigment.

In addition, in the solid-state imaging element according to the present invention, it is preferable that, in the solid-state imaging element described above, a ratio of the violet pigment to the violet dye in the color filter is 0.1 or more and 10 or less.

Also, in the solid-state imaging element according to the present invention, it is preferable that, in the solid-state imaging element described above, a ratio of a total amount of the violet dye and the violet pigment to the blue pigment in the color filter is 0.1 or more and 1 or less.

Furthermore, in the solid-state imaging element according to the present invention, it is preferable that, in the solid-state imaging element described above, the color filter contains the blue pigment, the violet dye, and the violet pigment in a range of 30% by mass or more and 70% by mass or less, relative to a total mass of solid content.

Moreover, in the solid-state imaging element according to the present invention, it is preferable that, in the solid-state imaging element described above, a refractive index of the color filter is 1.5 or more and less than 1.6 at the wavelength in which the transmittance becomes the maximum value.

In addition, in the solid-state imaging element according to the present invention, it is preferable that, in the solid-state imaging element described above, a thickness of the color filter is 0.3 µm or more and 1.0 µm or less.

Also, in the solid-state imaging element according to the present invention, it is preferable that, in the solid-state imaging element described above, a refractive index of the microlenses has a value of 1.60 or more and 1.65 or less within a wavelength range of 400 nm or more and 500 nm or less.

Furthermore, in the solid-state imaging element according to the present invention, it is preferable that, in the solid-state imaging element described above, a thickness of the microlenses is 0.3 µm or more and 1.0 µm or less.

### [Advantageous Effects of the Invention]

According to the solid-state imaging element of the present invention, because the transmittance of the color filter exhibits a maximum value between wavelengths of 400 nm to 500 nm, while also exhibiting a transmittance of 50% between wavelengths of 460 nm to 490 nm, and the refractive index of the color filter is a smaller value than that of the microlenses at the wavelength in which the transmittance becomes the maximum value, it is possible to prevent a decrease in the light focusing efficiency of blue light from the microlenses toward the photoelectric conversion element, and to improve the light focusing performance, and therefore, it is possible to improve the peak sensitivity between wavelengths of 400 nm to 500 nm.

### [Brief Description of the Drawings]

Fig. 1 is a cross-sectional view showing a schematic structure of essential parts of a main embodiment of a solid-state imaging element according to the present invention.
Fig. 2 is a graph showing the relationship between the wavelength and transmittance of color filters prepared as a test specimen and a comparative specimen.
Fig. 3 is a graph showing the relationship between the wavelength and refractive index of color filters and microlenses prepared as a test specimen and a comparative specimen.

### [Description of the Embodiments]

The embodiments of a solid-state imaging element according to the present invention will be described below with reference to the drawings. Note that the present invention is not limited to the following embodiments described based on the drawings, and specific technical matters described in each embodiment can naturally be combined as appropriate.

### [Main Embodiment]

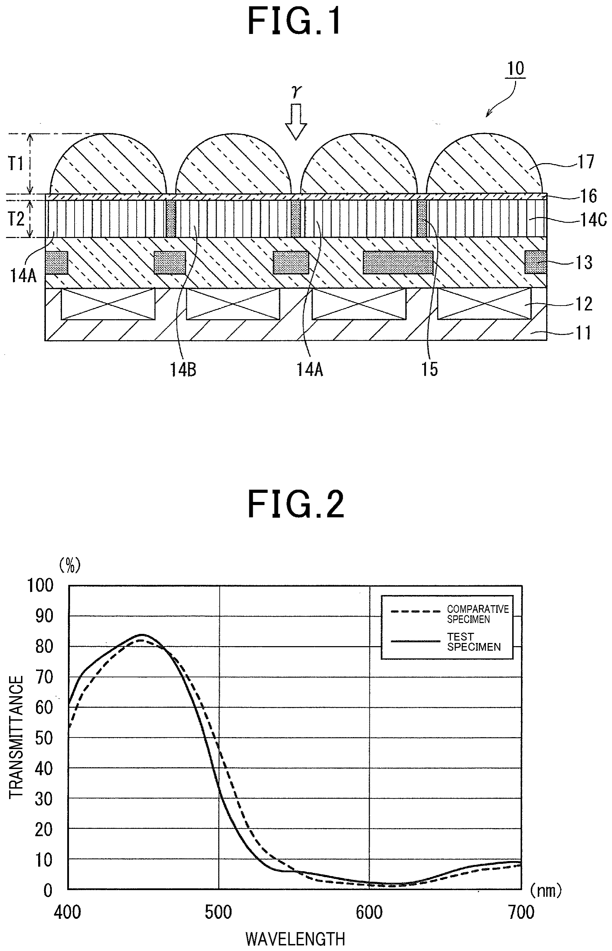

A main embodiment of a solid-state imaging element according to the present invention will be described below with reference to Figs. 1 to 3.

As shown in Fig. 1, in the interior of a semiconductor substrate 11, a plurality of photoelectric conversion elements 12, such as photodiodes that convert light into an electrical signal, are two-dimensionally arranged so as to correspond to pixels. Such a semiconductor substrate 11 is usually provided with a protective layer (not shown) on the outermost surface for the purpose of protecting and flattening the surface (light incident surface).

The semiconductor substrate 11 is formed of a material that transmits visible light, and can withstand a temperature of about 300°C. Examples of such materials include Si, oxides such as SiO₂, nitrides such as SiN, mixtures of these materials, and other Si-containing materials.

On the semiconductor substrate 11, a light-shielding layer 13 is arranged that shields a portion of the light that is incident so as to correspond to light-receiving regions of the photoelectric conversion elements 12. On the light-shielding layer 13, a plurality of color filters 14A to 14C of each color are arranged so as to correspond to respective photoelectric conversion element 12. The color filters 14A to 14C are arranged in a predetermined pattern, and correspond to the respective colors used for color separation of the incident light.

The color filters 14A to 14C are arranged in a Bayer array, which is a preset regular pattern corresponding to each of the plurality of photoelectric conversion elements 12 according to the pixel position. Note that the color filters 14A to 14C are not necessarily limited to being arranged in a Bayer array, and other types of arrays are also possible.

Partition walls 15 are respectively arranged between adjacent color filters 14A to 14C. Note that the arrangement of the partition walls 15 can be omitted. On the color filters 14A to 14C, a microlens layer 16 is arranged, on which a plurality of protruding microlenses 17, each having a hemispherical shape that corresponds to, and that causes light to enter, respective photoelectric conversion element 12, are provided. That is, the color filters 14A to 14C are arranged between the semiconductor substrate 11 and the microlens layer 16.

The microlenses 17 have a refractive index of 1.60 or more and 1.65 or less in a wavelength range of 400 nm or more and 500 nm or less. Examples of the material of microlenses 17 having such a refractive index include "TMR P15 (product number)", manufactured by Tokyo Ohka Kogyo Co., Ltd. Note that the microlenses 17 can also contain a filler such as a hollow silica filler.

The height (T1) of the microlenses 17, which is the shortest length connecting the bottom portion and top portion, is preferably 0.3 µm or more and 1.0 µm or less, and more preferably 0.4 µm or more and 0.7 µm or less. If the height is less than 0.3 µm, the light focusing properties are reduced, which is not preferable, and if the height exceeds 1.0 µm, patterning by a photolithography method becomes difficult, which is not preferable.

Further, the color filters 14A to 14C are made by adding a colorant of a predetermined color and various additives to a colorless and transparent resin material. Examples of the resin material of the color filters 14A to 14C include acrylic resins and epoxy resins.

In the color filter 14A, for example, a green pigment (GP) such as C.I. Pigment Green 7, 10, 36, 37, or 58, a zinc phthalocyanine pigment described in JP 2008-19383 A, JP 2007-320986 A, JP 2004-70342 A, or the like, or an aluminum phthalocyanine pigment described in JP 4893859 B, may be mixed as a colorant.

In the color filter 14B, for example, a red pigment (RP) such as C.I. Pigment Red 7, 14, 41, 48:1, 48:2, 48:3, 48:4, 57:1, 81, 81:1, 81:2, 81:3, 81:4, 122, 146, 149, 166, 168, 169, 176, 177, 178, 179, 184, 185, 187, 200, 202, 208, 210, 221, 224, 242, 246, 254, 255, 264, 268, 269, 270, 272, 273, 274, 276, 277, 278, 279, 280, 281, 282, 283, 284, 285, 286, or 287, a diketopyrrolopyrrole pigment described in JP 2011-523433 T, or a naphthol azo pigment described in JP 2013-161025 A, may be mixed as a colorant.

In the color filter 14C, for example, a blue pigment (BP) such as C.I. Pigment Blue 1, 1:2, 9, 14, 15, 15:1, 15:2, 15:3, 15:4, 15:6, 16, 22, 60, or 64, or a copper phthalocyanine pigment described in JP 2004-333817 A or JP 4893859 B, and a violet dye (VD) such as C.I. Acid Red 50, 51, 52, 87, 91, 92, 94, 289, or 388, C.I. Acid Violet 9, 30, or 102, C.I. Basic Red 1 (Rhodamine 6G), 2, 3, 4, 8, 10, or 11, C.I. Basic Violet 10 (Rhodamine B) or 11, C.I. Solvent Red 218, C.I. Mordant Red 27, C.I. Reactive Red 36 (Rose Bengal B), Sulforhodamine G, a xanthene dye described in JP 2010-32999 A or JP 4492760 B, or a cyanine dye, may be at least mixed as colorants. It is preferable that the color filter 14C also contains a violet pigment (VP) such as a dioxazine pigment, for example, C.I. Pigment Violet 1, 19, 23, 29, 32, 36, or 38.

Examples of the additive mentioned above include sensitizers, antioxidants, dissolved oxygen reducing agents, leveling agents, storage stabilizers, adhesion promoters, and dispersing aids.

In the color filter 14A, the green pigment (GP) is preferably contained in a range of 30% by mass or more and 65% by mass or less, and more preferably in a range of 50% by mass or more and 65% by mass or less, relative to the total mass of the solid content (TS). This is because, if the content is less than 50% by mass, it is difficult to sufficiently exhibit the function as a color filter, which is not preferable, and if the content exceeds 65% by mass, the photosensitive components tend to be insufficient and pattern formation becomes difficult, which is not preferable.

In the color filter 14B, the red pigment (RP) is preferably contained in a range of 30% by mass or more and 65% by mass or less, and more preferably in a range of 50% by mass or more and 65% by mass or less, relative to the total mass of the solid content (TS). This is because, if the content is less than 50% by mass, it is difficult to sufficiently exhibit the function as a color filter, which is not preferable, and if the content exceeds 65% by mass, the photosensitive components tend to be insufficient and pattern formation becomes difficult, which is not preferable.

Further, in the color filter 14C, the ratio (VP/VD) of the violet pigment (VP) to the violet dye (VD) is preferably 0.1 or more and 10 or less, and more preferably 0.1 or more and 1 or less. This is because, if the ratio is less than 0.1, the light resistance tends to decrease, which is not preferable, and if the ratio exceeds 10, color characteristics tend to deteriorate, which is not preferable.

In addition, in the color filter 14C, the ratio (VDP/BP) of the total amount (VDP) of the violet dye (VD) and the violet pigment (VP) to the blue pigment (BP) is preferably 0.1 or more and 1 or less, and more preferably 0.1 or more and 0.5 or less. This is because, if the ratio is less than 0.1, optical crosstalk with green tends to increase, and color reproducibility tends to deteriorate, which is not preferable, and if the ratio exceeds 1, transmittance tends to increase on the long wavelength side of the spectrum, and color purity tends to decrease, which is not preferable.

Further, in the color filter 14C, the blue pigment (BP), the violet dye (VD), and the violet pigment (VP) in total are preferably contained in a range of 30% by mass or more and 70% by mass or less, and more preferably in a range of 45% by mass or more and 55% by mass or less, relative to the total mass of the solid content (TS). This is because, if the content is less than 30% by mass, it is difficult to sufficiently exhibit the function as a color filter, which is not preferable, and if the content exceeds 70% by mass, a decrease in light transmittance may occur, which is not preferable.

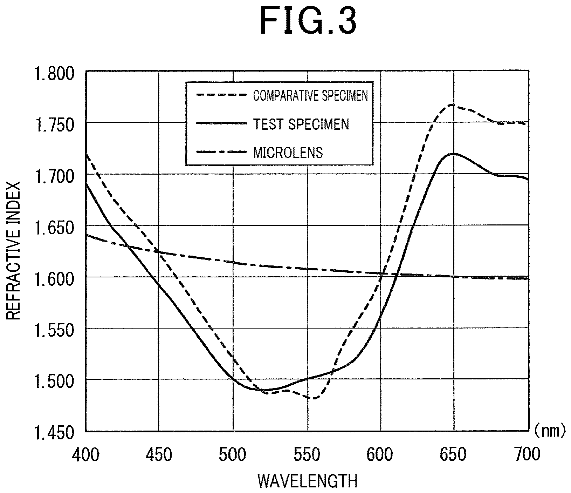

The color filter 14C according to the present embodiment described above has a transmittance in which the maximum value is within a wavelength range of 400 nm or more and 500 nm or less, that is, exhibits a maximum value between wavelengths of 400 nm to 500 nm (see Fig. 2). Further, the color filter 14C has a transmittance of 50% within a wavelength range of 460 nm or more and 490 nm or less, that is, exhibits a transmittance of 50% between 460 nm and 490 nm (see Fig. 2). In addition, the color filter 14C exhibits a refractive index that is a smaller value (1.5 or more and less than 1.6) than that of the microlenses 17 at the wavelength in which the transmittance becomes the maximum value (see Fig. 3).

The thickness T2 of the color filters 14A to 14C in the light transmission direction is preferably 0.3 µm or more and 1.0 µm or less, and more preferably 0.4 µm or more and 0.7 µm or less. This is because, if the thickness is less than 0.3 µm, it is difficult to sufficiently exhibit the function as a color filter, which is not preferable, and if the thickness exceeds 1.0 µm, light is less likely to reach the bottom portion of the film during exposure due to absorption by the coloring material, which tends to cause a decrease in the patterning properties, which is not preferable.

The solid-state imaging element 10 according to the present embodiment described above can be manufactured by applying a known method. That is, a light-shielding layer 13 is provided on the semiconductor substrate 11 provided with the photoelectric conversion elements 12, the color filters 14A to 14C and the partition walls 15 are provided on the light-shielding layer 13, and then the microlens layer 16 is further provided, and the microlenses 17 are formed on the microlens layer 16 by etching or the like.

In such a solid-state imaging element 10 according to the present embodiment, when light γ enters the microlenses 17, the light γ is focused by the microlenses 17, color-separated by the color filters 14A to 14C, and then delivered to respective photoelectric conversion element 12 via the light-shielding layer 13.

At this time, the color filter 14C has a transmittance that exhibits a maximum value within a wavelength range of 400 nm or more and 500 nm or less, the transmittance becomes 50% within a wavelength range of 460 nm or more and 490 nm or less, and the refractive index at the wavelength in which the transmittance becomes the maximum value is a smaller value (1.5 or more and less than 1.6) than that of the microlenses 17 (1.60 or more and 1.65 or less). Therefore, it is possible to prevent a decrease in the light focusing efficiency of blue light from the microlenses 17 toward the photoelectric conversion element 12, and to improve the light focusing performance.

Therefore, according to the solid-state imaging element 10 of the present embodiment, because a decrease in light focusing efficiency can be prevented, and the light collection performance can be improved, the peak sensitivity within a wavelength range of 400 nm or more and 500 nm or less can be improved.

Note that examples of substituents that generally contribute to the refractive index of the resin material constituting the microlenses and color filters primarily include -SC₆H₅ > -COC₆H₅ > -OC₆H₅ > -C₆H₅, which include a benzene ring, followed by -NH₂ > -NO₂ > -OH > -CN > - OCH₃, and heavy halogens (-I) > -Br > -Cl. On the other hand, a pyridine structure or an alkyl group does not significantly change the refractive index, and -F has the effect of significantly reducing the refractive index due to its small polarizability.

Here, in order to confirm the effects of the solid-state imaging element according to the present invention, a test specimen of the solid-state imaging element 10 shown in Fig. 1 described in the embodiment above was produced under the conditions below, and a comparative specimen serving as a comparison target produced under the conditions below.

### <Test Specimen>

### <<Color Filter 14C>>

· Resin material: Acrylic resin
· Blue pigment (BP): Copper phthalocyanine-based pigment
· Violet dye (VD): Xanthene-based dye
· Violet pigment (VP): Dioxazine-based pigment
· Ratio (VP/VD) of violet pigment (VP) to violet dye (VD): 0.5
· Ratio (VDP/BP) of the total amount (VDP) of violet dye (VD) and violet pigment (VP) to blue pigment (BP): 0.42
· Ratio (BVPD/TS) of the total mass (BVPD) of blue pigment (BP), violet dye (VD), and violet pigment (VP) to total solid content (TS): 53%
· Thickness: 0.7 µm
· Transmittance: See Fig. 2
· Refractive index: See Fig. 3

### <<Microlens 17>>

· Resin material: Phenol-based resin
· Height: 0.5 µm
· Refractive index: See Fig. 3

### <Comparative Specimen>

The same conditions as the test specimen described above were used, except that the mixing of the violet dye (VD) was omitted.
· Transmittance: See Fig. 2
· Refractive index: See Fig. 3

As can be seen from Fig. 2, in the color filters described above, the transmittance of both the test specimen and the comparative specimen exhibited the maximum value at a wavelength of 450 nm. As can be seen from Fig. 3, the refractive index of the comparative specimen (1.625) at a wavelength of 450 nm was equal to the refractive index of the microlenses. In contrast, the refractive index of the test specimen (1.59) was smaller than the refractive index (1.625) of the microlenses.

When the sensor characteristics of the test specimen and the comparative specimen were measured using a tester device, it was confirmed that the peak sensitivity at a wavelength of 450 nm was improved by 3.2% in the test specimen compared to the comparative specimen. This is considered to be because this value is larger than the difference (2.1%) between the transmittance of the color filter of the test specimen (83.7%) at a wavelength of 450 nm, and the transmittance of the color filter of the comparative specimen (81.6%) at a wavelength of 450 nm, which improves the light focusing efficiency, and enables the light focusing performance to be improved.

Further, color filters with modified values for VP/VD, VDP/BP, and BVPD/TS were prepared as Examples 1 to 10, and the peak transmittances were determined. Then, the differences in peak transmittance (values obtained by subtracting the value of the comparative specimen from the value of each of Examples 1 to 10) were calculated, which represent the differences with the transmittance of the color filter of the comparative specimen (81.6%) at a wavelength of 450 nm. The results are shown in Table 1 below.

**[Table 1]**

| Example | VP/VD | VDP/BP | BVPD/TS | Difference in peak transmittance |
|---|---|---|---|---|
| 1 | 10.0 | 0.42 | 53% | 0.8% |
| 2 | 1.0 | 0.42 | 53% | 4.6% |
| 3 | 0.1 | 0.42 | 53% | 8.6% |
| 4 | 0.5 | 1.00 | 53% | 3.0% |
| 5 | 0.5 | 0.50 | 53% | 5.6% |
| 6 | 0.5 | 0.10 | 53% | 10.0% |
| 7 | 0.5 | 0.42 | 70% | 2.2% |
| 8 | 0.5 | 0.42 | 55% | 5.7% |
| 9 | 0.5 | 0.42 | 45% | 8.2% |
| 10 | 0.5 | 0.42 | 30% | 12.0% |

As can be seen from Table 1, in Examples 1 to 10, all differences in the peak transmittance were positive values (0.8% or more), confirming the effect of the solid-state imaging element according to the present invention.

### [Industrial Applicability]

The solid-state imaging element according to the present invention can improve peak sensitivity between wavelengths of 400 nm to 500 nm, and can therefore be used very effectively in various industries.

### [Reference Signs List]

10 Solid-state imaging element
11 Semiconductor substrate
12 Photoelectric conversion element
13 Light-shielding layer
14A to 14C Color filter
15 Partition wall
16 Microlens layer
17 Microlens

## Claims

1. A solid-state imaging element comprising:
a semiconductor substrate having a plurality of photoelectric conversion elements;
a microlens layer having a plurality of microlenses that each cause light to enter the photoelectric conversion elements of the semiconductor substrate; and
a color filter provided between the semiconductor substrate and the microlens layer; wherein
the color filter
has a transmittance that exhibits a maximum value between wavelengths of 400 nm to 500 nm, while also exhibiting a transmittance of 50% between wavelengths of 460 nm to 490 nm, and
has a refractive index that is a smaller value than that of the microlenses at a wavelength in which the transmittance becomes the maximum value.

2. The solid-state imaging element according to claim 1, wherein
the color filter contains a blue pigment and a violet dye.

3. The solid-state imaging element according to claim 2, wherein
the color filter further contains a violet pigment.

4. The solid-state imaging element according to claim 3, wherein
in the color filter, a ratio of the violet pigment to the violet dye is 0.1 or more and 10 or less.

5. The solid-state imaging element according to claim 4, wherein
in the color filter, a ratio of a total amount of the violet dye and the violet pigment to the blue pigment is 0.1 or more and 1 or less.

6. The solid-state imaging element according to claim 5, wherein
the color filter contains the blue pigment, the violet dye, and the violet pigment in a range of 30% by mass or more and 70% by mass or less, relative to a total mass of solid content.

7. The solid-state imaging element according to any one of claims 1 to 6, wherein
a refractive index of the color filter is 1.5 or more and less than 1.6 at the wavelength in which the transmittance becomes the maximum value.

8. The solid-state imaging element according to any one of claims 1 to 6, wherein
a thickness of the color filter is 0.3 µm or more and 1.0 µm or less.

9. The solid-state imaging element according to any one of claims 1 to 6, wherein
a refractive index of the microlenses is a value of 1.60 or more and 1.65 or less within a wavelength range of 400 nm or more and 500 nm or less.

10. The solid-state imaging element according to any one of claims 1 to 6, wherein
a height of the microlenses is 0.3 µm or more and 1.0 µm or less.
